# EUROPÄISCHE PATENTSCHRIFT

(11) **EP 0 377 873 B1**
(45) Veröffentlichungstag und Bekanntmachung des Hinweises auf die Patenterteilung: **10.08.1994**
(21) Anmeldenummer: 89123577.2
(22) Anmeldetag: 20.12.1989
(51) Int. Cl.: B23K 3/04

(54) **Lötvorrichtung mit mindestens einer durch elektrische Widerstandswärme erhitzbaren Bügelelektrode**
Soldering device with at least one stirrup electrode heated by electric thermal resistance
Dispositif de brasage avec au moins une électrode à étrier à chauffage par résistance électrique

(30) Priorität: 10.01.1989 DE 3900521
(43) Veröffentlichungstag der Anmeldung: 18.07.1990
(73) Patentinhaber: SIEMENS AKTIENGESELLSCHAFT, 80333 München (DE)
(72) Erfinder: Schuster, Rudolf, D-8011 Heimstetten (DE); Raschke, Josef, D-8011 Gelting (DE); Kamperdicks, Klaus, D-8000 München 82 (DE)

(56) Entgegenhaltungen:
- DE-A- 2 260 722
- IBM TECHNICAL DISCLOSURE BULLETIN vol. 31, no. 3, August 1988, Armonk, NY (USA)Seiten 98 - 99; "Boron - Nitride coated thermode blade for surface - mountedtechnology interconnections"

## Beschreibung

Die Erfindung betrifft eine Lötvorrichtung zum Auflöten hochpoliger elektronischer Bauelemente auf Leiterplatten, mit mindestens einer durch elektrische Widerstandswärme erhitzbaren Bügelelektrode und einer auf die Unterseite des Lötsteges der Bügelelektrode aufgebrachten elektrisch isolierenden Keramikbeschichtung.

Eine derartige Lötvorrichtung, die jedoch keine elektrisch isolierende Keramikbeschichtung aufweist, ist beispielsweise aus der DE-A-31 49 236 bekannt. Der Elektrodenhalter dieser bekannten Lötvorrichtung umfaßt elektrisch voneinander isolierte, kleine Säulen aus leitfähigem Material, zwischen deren Enden in auswechselbarer Weise mindestens zwei Bügelelektroden befestigt sind. Die U-förmigen Bügelelektroden, die durch elektrische Widerstandswärme erhitzt werden können, sind aus einer ebenen Platte aus einem Widerstandsmaterial wie Tantal oder Molybdän hergestellt und in der Weise angebracht, daß sie mit der Unterseite ihres Lötsteges in Kontakt mit den zu verlötenden Elementen kommen. Bei einer Anzahl von zwei oder vier Bügelelektroden werden für die Elektrodenhalter insgesamt vier kleine Säulen benötigt, die auf einer jeweiligen Diagonalen der Lötvorrichtung angeordnet sind und durch mehrere kreuzförmige Verstrebungen mechanisch miteinander verbunden sind. Zur Stromversorgung von vier Bügelelektroden werden zwei auf einer Diagonale liegende kleine Säulen mit dem einen Pol einer Stromquelle verbunden, während die beiden anderen kleinen Säulen mit dem anderen Pol der Stromquelle verbunden werden.

Aus der DE-A-28 18 958 ist eine andere Lötvorrichtung bekannt, bei welcher der Elektrodenhalter zwei elektrisch voneinander isolierte kleine Säulen aus leitfähigem Material umfaßt, zwischen deren Enden eine einzige Bügelelektrode in auswechselbarer Weise befestigt ist. Diese Bügelelektrode besitzt jedoch insgesamt vier Lötstege, welche die Form eines einstückigen, rechteckförmigen Rahmens aufweisen, wobei zwei einander gegenüberliegende Lötstege über nach oben ragende Fortsätze an den zugeordneten kleinen Säulen auswechselbar befestigt sind.

Aus der EP-A-0 011 046 ist eine weiter Lötvorrichtung bekannt, bei welcher eine einzige an einem Elektrodenhalter befestigte Bügelelektrode insgesamt vier paarweise einander gegenüberliegende Lötstege besitzt, welche die Form eines einstückigen, rechteckförmigen Rahmens aufweisen. Die vorstehend geschilderten bekannten Lötvorrichtungen werden insbesondere für das Auflöten hochpoliger elektronischer Bauelemente wie Mikropacks, Flatpacks und dergleichen auf Leiterplatten eingesetzt, wobei die Widerstandserwärmung der Bügelelektroden durch Stromimpulse vorgenommen wird. Dabei muß sowohl vor dem Lötvorgang als auch während der gesamten Dauer des Lötvorganges ein sicherer Kontakt zwischen den Arbeitsflächen der Bügelelektroden, den Anschlußbeinchen der Bauelemente und den Leiterbahnen bzw. Anschlußpads der Leiterplatten gewährleistet sein. Diese Forderung kann jedoch selbst dann nicht immer gewährleistet werden, wenn die Lötstege absolut parallel zur Lötstelle ausgerichtet sind. Ein weiteres Problem kann darin bestehen, daß beim Auflöten mehrpoliger Bauelemente auf mehrlagige Leiterplatten, der den Bügelelektroden zugeführte Strom über niederohmige Leiterbahnen auf den Innenlagen der mehrlagigen Leiterplatte abfließt und dadurch eine für den beabsichtigten Lötvorgang ausreichend Widerstandserwärmung der Bügelelektroden nicht mehr gewährleistet ist.

Zur Vermeidung des vorstehend genannten Problems wird in der DE-A-2 260 722 vorgeschlagen, einen Keramikstreifen zu metallisieren und durch Hartlöten mit der Unterseite der Bügelelektrode zu verbinden. Als Keramikmaterialien sind dabei Aluminiumoxid und Berylliumoxid angegeben, während als Material für die Bügelelektrode eine Nickel-Eisen-Legierung bevorzugt wird, die 54 % Eisen, 28 % Nickel und 18 % Kobalt enthält. Obwohl die Ausdehnungsbeiwerte der angegebenen Materialien ähnlich sind, wird ein Ausgleichskonzept als notwendig angesehen, welches Verformungskräften durch die Anbringung eines zweiten Keramikstreifens auf der gegenüberliegenden Seite der Bügelelektrode entgegenwirken soll.

Aus IBM TECHNICAL DISCLOSURE BULLETIN, vol. 31, no. 3, August 1988, Seiten 98 bis 99 ist es auch bereits bekannt, auf Bügelelektroden aus Titan eine Keramikbeschichtung aus Bornitrid aufzubringen. Auch hier wird als Ausgleichskonzept eine zusätzliche Keramikbeschichtung auf die Oberseite der Lötstege aufgebracht.

Der Erfindung liegt die Aufgabe zugrunde, eine Lötvorrichtung der eingangs genannten Art so zu verbessern, daß während der gesamten Dauer des Lötvorganges ein sicherer Kontakt zwischen den Lötstegen, den Anschlußbeinchen der Bauelemente und den Leiterbahnen bzw. Anschlußpads der Leiterplatten gewährleistet ist und gleichzeitig eine ausgezeichnete Haftung und hohe Standzeit der Keramikbeschichtung erzielt wird.

Diese Aufgabe wird erfindungsgemäß dadurch gelöst, daß zumindest der der Lötstelle zugewandte Lötsteg der Bügelelektrode aus einer Nickel-Eisen-Legierung mit einem Nickelgehalt zwischen 28 und 30 Gew.-%, einem Kobaltgehalt zwischen 17 und 19 Gew.-% und einem Eisengehalt zwischen 50 und 55 Gew.-% besteht und daß die Keramikbeschichtung aus Titanoxid oder Aluminiumoxid oder Aluminiumnitrid oder Berylliumoxid oder Titanaluminiumnitrid oder Chromoxid ist.

Der Erfindung liegt die Erkenntnis zugrunde, daß nach dem Aufsetzen der Bügelelektrode die Wärmeableitung in die Lötstelle zu einer Abkühlung der Unterseite des Lötsteges führt, wobei diese Abkühlung ihrerseits einen thermischen Verzug des Lötsteges und damit einen unzureichenden Kontakt zwischen Lötsteg und Lötstelle zur Folge hat. Dieser nachteilige Effekt kann jedoch durch die Verwendung eines Lötsteges aus einer Nickel- Eisen-Legierung mit einem Nickelgehalt zwischen 28 und 30 Gew.-%, einem Kobaltgehalt zwischen 17 und 19 Gew.-% und einem Eisengehalt zwischen 50 und 55 Gew.-% zumindest weitgehend kompensiert werden, da diese Legierungen sich durch extrem niedrige thermische Ausdehnungskoeffizienten in dem für Lötungen relevanten Temperaturbereich auszeichnen. Bei einer derartigen Legierung bewirkt der Kobaltzusatz vor allem eine Erhöhung der Knickpunkttemperatur der Ausdehnungskurve um ca. 100° C, was einer optimalen Abstimmung des Ausdehnungsverhaltens auf die bei der Verwendung von Zinn-Blei-Loten erforderlichen Arbeitstemperaturen entspricht. Zusätzlich ist auf die Unterseite des Lötsteges der Bügelelektrode eine elektrisch isolierende Keramikbeschichtung aus Titanoxid oder Aluminiumoxid oder Aluminiumnitrid oder Berylliumoxid oder Titanaluminiumnitrid oder Chromoxid aufgebracht. Durch eine derartige Keramikbeschichtung kann ein Abfließen des den Bügelelektroden zugeführten Stroms über niederohmige Leiterbahnen mit Sicherheit ausgeschlossen werden. Andererseits ist auch das thermische Verhalten der angegebenen Nickel-Eisen-Legierung hervorragend auf das thermische Verhalten derartiger Keramikbeschichtungen abgestimmt, d.h. es ergibt sich eine optimale Haftung der Keramikbeschichtung auf der Unterseite des Lötsteges. Diese gute Haftung ermöglicht dann auch größere Schichtdicken der Keramikbeschichtung, wobei die Keramikbeschichtung vorzugsweise eine Stärke zwischen 50 und 100 µm aufweisen soll. Bei einer derartigen Stärke der Keramikbeschichtung ergibt sich eine hohe Standzeit, da die Keramikbeschichtung beim Planschleifen und Reinigen im Fertigungseinsatz auch etwas abgetragen werden kann ohne die elektrisch isolierende Wirkung zu beeinträchtigen.

Ein Ausführungsbeispiel der Erfindung ist in der Zeichnung dargestellt und wird im folgenden näher beschrieben.
Es zeigen:
Figur 1 eine Lötvorrichtung mit insgesamt vier Bügelelektroden und
Figur 2 einen Querschnitt, welcher die Aufbringung einer Keramikbeschichtung auf die Unterseite einer Bügelelektrode aufzeigt.

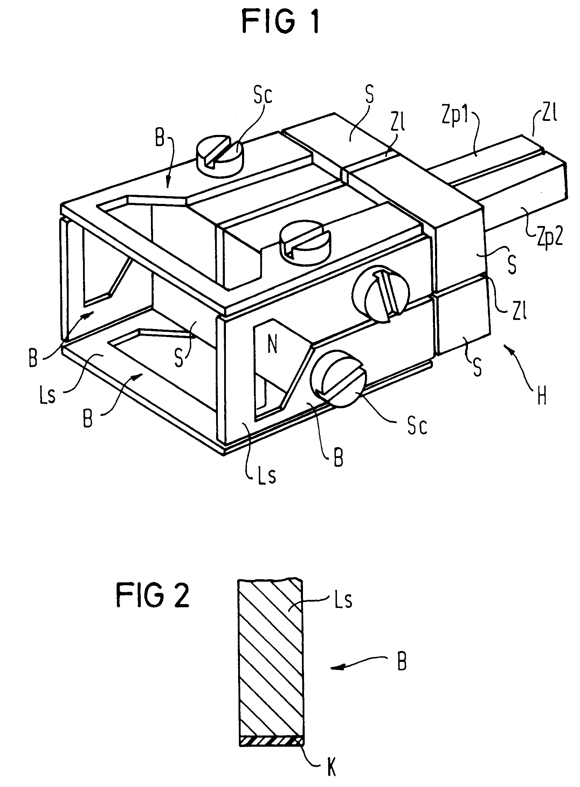

Figur 1 zeigt in perspektivischer Darstellung eine Lötvorrichtung, die für das Auflöten von Mikropacks auf mehrlagige Leiterplatten eingeseetzt wird und insgesamt vier Bügelelektroden B besitzt, deren Lötstege Ls zusammen die Form eines geschlossenen Rechtecks bilden. Der Elektrodenhalter H der Lötvorrichtung umfaßt vier kleine Säulen S, die durch Zwischenlagen Zl elektrisch voneinander isoliert sind. Dabei ist jede der U-förmig ausgebildeten Bügelelektroden B jeweils mit einem Schenkel an einer Säule S und mit dem anderen Schenkel an der benachbarten Säule S mittels Schrauben Sc auswechselbar befestigt. Zur Stromversorgung der vier Bügelelektroden B werden zwei auf einer Diagonale liegenden Säulen S über einen ersten Zapfen Zp1 mit dem einem Pol einer in Fig. 1 nicht näher dargestellten Stromquelle verbunden, während die beiden anderen Säulen S über einen zweiten Zapfen Zp2 mit dem anderen Pol der Stromquelle verbunden werden. Die beiden im Querschnitt rechteckig ausgebildeten und durch eine Zwischenlage Zl elektrisch voneinander isolierten Zapfen Zp1 und Zp2 dienen dabei gleichzeitig als Einspannteil der gesamten Lötvorrichtung, die in einem in drei zueinander senkrechten Richtungen verfahrbaren Kopf aufgenommen wird.

Um einen thermischen Verzug der Lötstege beim Lötvorgang zu verhindern und damit einen sicheren Kontakt zwischen Lötsteg und Lötstelle während des Lötvorganges zu gewährleisten, werden die Bügelelektroden B aus einem Werkstoff mit extrem niedrigem thermischen Ausdehnungskoeffizienten gefertigt. Als Beispiel wird eine Nickel-Eisen-Legierung mit folgender chemischer Zusammensetzung (Gew.-%) genannt.

| | |
|---|---|
| Ni | 29 |
| Mn | 0,2 |
| Si | 0,2 |
| Fe | Rest |
| Co | 18 |
| C | 0,03 |
| Ausdehnungsbeiwert (10⁻⁶/K) von 20 bis 200° C: 5,5 | |

Damit beim Auflöten mehrpoliger Bauelemente auf mehrlagige Leiterplatten der den Bügelelektroden B in Form von Stromimpulsen zugeführte Strom beim Aufsetzen auf die Lötstelle nicht über niederohmige Leiterbahnen abfließen kann, sind die Unterseiten der Lötstege Ls gemäß Fig. 2 mit einer elektrisch isolierenden Keramikbeschichtung K versehen, die beispielsweise eine Stärke von 75 µm aufweist. Um eine feste Haftung dieser Keramikschicht K zu gewährleisten wird dabei das thermische Verhalten des Werkstoffes der Bügelelektroden B an das thermische Verhalten der Keramikbeschichtung K angeglichen. Das thermische Verhalten des Werkstoffes der Bügelelektroden B kann dabei über das Verhältnis Nickel/Eisen und/oder durch Zulegieren optimal an das thermische Verhalten verschiedener Keramiken angeglichen werden. Als Keramiken sind Titanoxid, Aluminiumoxid, Aluminiumnitrid, Berylliumoxid, Titanaluminiumnitrid oder Chromoxid geeignet. Eine geeignete Paarung bilden dann beispielsweise die vorstehend angegebene Nickel-Eisen-Legierung und Titanaluminiumnitrid.

## Patentansprüche

1. Lötvorrichtung zum Auflöten hochpoliger elektronischer Bauelemente auf Leiterplatten, mit mindestens einer durch elektrische Widerstandswärme erhitzbaren Bügelelektrode (B) und einer auf die Unterseite des Lötsteges (Ls) der Bügelelektrode (B) aufgebrachten elektrisch isolierenden Keramikbeschichtung (K),
**dadurch gekennzeichnet,**
daß zumindest der der Lötstelle zugewandte Lötsteg (Ls) der Bügelelektrode (B) aus einer Nickel-Eisen-Legierung mit einem Nickelgehalt zwischen 28 und 30 Gew.-%, einem Kobaltgehalt zwischen 17 und 19 Gew.-% und einem Eisengehalt zwischen 50 und 55 Gew.-% besteht und daß die
Keramikbeschichtung (K) aus Titanoxid oder Aluminiumoxid oder Aluminiumnitrid oder Berylliumoxid oder Titanaluminiumnitrid oder Chromoxid ist.

2. Lötvorrichtung nach Anspruch 1,
**dadurch gekennzeichnet,**
daß die Keramikbeschichtung (K) eine Stärke zwischen 50 und 100 Mikrometern aufweist.

## Claims

1. Soldering device for soldering electronic components having a large number of poles onto printed circuit boards, having at least one bit electrode (B) which can be heated by electrical resistance heat and having an electrically insulating ceramic coating (K) which is applied onto the underneath of the soldering web (Ls) of the bit electrode (B), characterized in that at least that soldering web (Ls) of the bit electrode (B) which faces the soldering point is composed of a nickeliron alloy having a nickel content of between 28 and 30% by weight, a cobalt content of between 17 and 19% by weight, and an iron content of between 50 and 55% by weight, and in that the ceramic coating (K) is composed of titanium oxide, aluminium oxide, aluminium nitride, beryllium oxide, titanium aluminium nitride or chromium oxide.

2. Soldering device according to Claim 1, characterized in that the ceramic coating (K) has a thickness of between 50 and 100 micrometres.

## Revendications

1. Dispositif de brasage pour la fixation par brasage de composants électroniques, comportant un grand nombre de bornes, sur des plaquettes à circuit imprimé, comprenant au moins une électrode en forme d'étrier (B) qui peut être chauffée par la chaleur produite par une résistance électrique, et une couche céramique (K) électriquement isolante déposée sur l'envers de la barrette de brasage (Ls) de l'électrode en forme d'étrier (B),
caractérisé en ce qu'au moins la barrette de brasage (Ls), tournée vers le point de brasage, de l'électrode en forme d'étrier (B) est en un alliage fernickel ayant une teneur en nickel comprise entre 28 et 30 % en poids, une teneur en cobalt comprise entre 17 et 19 % en poids et une teneur en fer compris entre 50 et 55 % en poids, et en ce que la couche céramique (K) est en oxyde de titane ou en oxyde d'aluminium ou en nitrure d'aluminium ou en oxyde de béryllium ou en nitrure d'aluminium-titane ou en oxyde de chrome.

2. Dispositif de brasage selon la revendication 1, caractérisé en ce que la couche céramique (K) a une épaisseur comprise entre 50 et 100 micromètres.
